# EUROPÄISCHE PATENTANMELDUNG

(11) **EP 4 369 391 A1**
(43) Veröffentlichungstag der Anmeldung: **15.05.2024**
(21) Anmeldenummer: 23202535.3
(22) Anmeldetag: 09.10.2023
(51) Int. Cl.: H01L 23/473

(54) **KÜHLEINRICHTUNG**

(30) Priorität: 10.10.2022 DE 102022126106
(71) Anmelder: Erwin Quarder Systemtechnik GmbH, 32339 Espelkamp (DE)
(72) Erfinder: Siewert, Georg, 35415 Pohlheim (DE); Heitbrink, Alexander, 32351 Stemwede (DE)
(74) Vertreter: Geskes, Christoph

(57) **Zusammenfassung**

Die vorliegende Erfindung betrifft eine Kühleinrichtung zum Abführen von Wärme eines zu kühlenden Gegenstands, wie etwa einer insbesondere auf einer Leiterplatte angeordneten Elektronikkomponente, beispielsweise eines Chips, mit einer Kühlfluidleitung zum Durchfluss von Kühlfluid, mit einem Grundbauteil (11), das einen oder mehrere Kühlfluidleitungsabschnitte der Kühlfluidleitung aufweist, und mit einem an einem zu kühlenden Gegenstand anordenbaren, insbesondere aus massivem Material bestehenden, vorzugsweise plattenförmigen Kühlkörper (14) zur Aufnahme von Abwärme von dem zu kühlenden Gegenstand sowie zur Weiterleitung der Abwärme an im Betrieb der Kühleinrichtung durch die Kühlfluidleitung der Kühleinrichtung fließendes Kühlfluid, insbesondere einem solchen Kühlkörper (14) aus Metall oder einer wärmeleitenden Metalllegierung. Die Erfindung ist dadurch gekennzeichnet, dass der Kühlkörper (14) an einem mindestens einen Kühlfluidleitungsabschnitt der Kühlfluidleitung aufweisenden Kühlbauteil (12) der Kühleinrichtung angeordnet ist, das unter fluidleitendem Anschluss dieses Kühlfluidleitungsabschnitts an einen Kühlfluidleitungsabschnitt des Grundbauteils (11) bewegbar mit dem Grundbauteil (11) verbunden ist, sodass das Kühlbauteil (12) und das Grundbauteil (11) zur Anpassung der Position des Kühlkörpers (14) des Kühlbauteils (12) bedarfsweise relativ zueinander entweder aufeinander zu- oder voneinander wegbewegt werden können.

## Beschreibung

Die vorliegende Erfindung betrifft eine Kühleinrichtung zum Abführen von Wärme eines zu kühlenden Gegenstands, wie etwa einer insbesondere auf einer Leiterplatte angeordneten Elektronikkomponente, beispielsweise eines Prozessorchips, mit einer Kühlfluidleitung zum Durchfluss von Kühlfluid, mit einem Grundbauteil, das einen oder mehrere Kühlfluidleitungsabschnitte der Kühlfluidleitung aufweist, und mit einem an einem zu kühlenden Gegenstand anordenbaren, insbesondere aus massivem Material bestehenden, vorzugsweise plattenförmigen Kühlkörper zur Aufnahme von Abwärme von dem zu kühlenden Gegenstand sowie zur Weiterleitung der Abwärme an im Betrieb der Kühleinrichtung durch die Kühlfluidleitung der Kühleinrichtung fließendes Kühlfluid, insbesondere einem solchen Kühlkörper aus Metall oder einer wärmeleitenden Metalllegierung.

Kühleinrichtungen zum Abführen von Wärme von zu kühlenden Gegenständen werden auch als Wärmetauscher bezeichnet und in vielen Bereichen der Technik eingesetzt. Besondere Bedeutung kommt solchen Kühleinrichtungen unter anderem bei der Kühlung von Batterie- bzw. Akkumulatorensystemen für Elektrofahrzeuge zu, aber auch von Leistungselektronikbauteilen, von Busbars oder von Prozessorchips. Die eingangs genannte Kühleinrichtung ist dabei in der Regel Bestandteil eines Kühlsystems inkl. Pumpe und anderen Bauteilen, wobei das System dafür sorgt, dass Kühlmedium, wie etwa Wasser oder dergleichen, kontinuierlich durch die Kühleinrichtung geführt wird.

Bei der eingangs beschriebenen Art von Kühleinrichtungen ist der eigentliche, in der Regel an dem zu kühlenden Gegenstand anliegende Kühlkörper häufig Teil des Grundbauteils, das Kühlfluidleitungsabschnitte der Kühlfluidleitung der Kühleinrichtung für den Zu- und Ablauf des Kühlmediums aufweist. Er kann beispielsweise die einstückig flächige Unterseite des Grundbauteils der Kühleinrichtung bilden und mit dieser auf die Stirnseiten von mehreren benachbarten zu kühlenden Gegenständen aufgesetzt werden.

Diese Bauform von Kühleinrichtungen ist unter anderem dann nachteilig, wenn gleichzeitig mehrere benachbarte Gegenstände gekühlt werden sollen, deren zu kühlenden Stirnseiten zwar theoretisch in einer Ebene liegen sollten, aber beispielsweise aufgrund von Herstellungstoleranzen geringfügige Höhenunterschiede aufweisen. Diese Toleranzen können zwar in Grenzen mit Zwischenschichten aus Wärmeleitpaste ausgeglichen werden. Diese Wärmeleitpaste verschlechtert allerdings dickenabhängig die Wärmeabfuhr von den zu kühlenden Gegenständen. Bei besonders wärmesensiblen Bauteilen bzw. bei Bauteilen mit starker Wärmeerzeugung, wie etwa Hochleistungs-Chips, kann dies kritisch sein, sodass nur sehr dünne Schichten von Wärmeleitpaste zulässig sind. Die Herstellungstoleranzen übersteigen diese zulässige Schichtdicke allerdings häufig.

Aufgabe der vorliegenden Erfindung ist es daher, die eingangs genannten Kühleinrichtungen weiterzuentwickeln. Insbesondere sollen auch größere Herstellungstoleranzen kompensierbar sein.

Diese Aufgabe wird gelöst durch Kühleinrichtung mit den Merkmalen des Anspruchs 1.

Eine erfindungsgemäße Kühleinrichtung ist dementsprechend dadurch gekennzeichnet, dass der Kühlkörper an einem einen Kühlfluidleitungsabschnitt der Kühlfluidleitung der Kühleinrichtung aufweisenden Kühlbauteil der Kühleinrichtung angeordnet ist, das unter fluidleitendem Anschluss dieses Kühlfluidleitungsabschnitts an einen Kühlfluidleitungsabschnitt des Grundbauteils bewegbar mit dem Grundbauteil verbunden ist, sodass das Kühlbauteil und das Grundbauteil zur Anpassung der Position des Kühlkörpers des Kühlbauteils bedarfsweise relativ zueinander entweder aufeinander zu- oder voneinander wegbewegt werden können.

Vorteilhafterweise ist dementsprechend erfindungsgemäß der Kühlkörper nicht mehr Teil des Grundbauteils der Kühleinrichtung, sondern an einem insofern separaten Kühlbauteil angeordnet bzw. ggf. Teil desselben, das wiederum bewegbar mit dem Grundbauteil verbunden ist. Vorteilhafterweise könnte somit beispielsweise auch nach einer bereits erfolgten, ortsfesten Anordnung des Grundbauteils der Kühleinrichtung (vor oder sogar noch im Betrieb derselben) noch die Relativposition des Kühlkörpers des Kühlbauteils verändert werden.

Somit wäre beispielsweise denkbar, dass das Grundbauteil einen weiteren (ggf. unbewegbaren) Kühlkörper aufweist und dass die Kühleinrichtung im Einsatz zunächst so positioniert wird, dass dieser weitere Kühlkörper an einem ersten zu kühlenden Gegenstand angeordnet bzw. - ggf. unter Vermittlung einer Wärmeleitpaste - an dessen zu kühlende Anlagefläche angelegt wird. Der Kühlkörper des bewegbar mit dem Grundbauteil verbunden Kühlbauteils könnte dann aufgrund seiner Bewegbarkeit relativ zu dem Grundbauteil an einem anderen zu kühlenden Gegenstand angeordnet werden, der sich beispielsweise zwar grob in derselben Ebene wie der erste zu kühlende Gegenstand befindet, dessen zu kühlende Fläche bzw. dessen Anlagefläche aber beispielsweise aufgrund von Herstellungstoleranzen gegebenenfalls in seiner Höhenposition etwas von der Anlagefläche des ersten zu kühlenden Gegenstands abweicht.

Es versteht sich im Übrigen, dass erfindungsgemäß nicht nur Anpassungen der Position des Kühlkörpers des Kühlbauteils im Rahmen von Herstellungstoleranzen möglich sind, sondern auch - je nach Umsetzung des erfindungsgemäßen Grundgedankens - auch im größeren Maßstab.

Was den Kühlkörper des bewegbar mit dem Grundbauteil verbundenen Kühlbauteils betrifft, so ist dieser vorzugsweise plattenförmig ausgebildet und/oder weist Kühlrippen auf.

Gemäß einer bevorzugten Ausführungsform der Erfindung weist der (insbesondere ortsfest an dem Grundbauteil angeordnete) Kühlfluidleitungsabschnitt des Grundbauteils und der (insbesondere ortsfest an dem Kühlbauteil angeordnete) Kühlfluidleitungsabschnitt des bewegbar mit dem Grundbauteil verbundenen Kühlbauteils jeweils einen vorzugsweise endständigen, insbesondere hohlzylindrischen Hohlkörper(teil)abschnitt auf. Für die erfindungsgemäße bewegbare Verbindung von Grundbauteil und Kühlbauteil sind dabei die beiden Hohlkörper(teil)abschnitte, insbesondere gleitend, axial bewegbar fluidleitend miteinander verbunden. Dies vorzugsweise, indem der eine Hohlkörperabschnitt, insbesondere der Hohlkörperabschnitt des Kühlbauteils, passgenau koaxial in den Innenraum des anderen Hohlkörperabschnitts, insbesondere des Hohlkörperabschnitts des Grundbauteils, eingesetzt bzw. eingeschoben ist. Dabei kann zur Abdichtung der beiden relativ zueinander bewegbaren Hohlkörperabschnitte gegeneinander vorgesehen sein, (mindestens) einen Dichtring zu verwenden.

Über die vorgenannten Hohlkörperabschnitte könnte dem Kühlbauteil bzw. dem Kühlfluidleitungsabschnitt desselben das Kühlfluid beispielsweise zugeführt werden. Zweckmäßigerweise wird das Kühlfluid dann, wenn es die über den Kühlkörper aufgenommene Abwärme des zu kühlenden Gegenstands aufgenommen hat, wieder aus dem Kühlbauteil abgeführt, und zwar vorzugsweise wieder zurück zu dem Grundbauteil bzw. zurück in einen weiteren/anderen Kühlfluidleitungsabschnitt des Grundbauteils. Entsprechend würde das Kühlfluid zunächst in den (ersten) Kühlfluidleitungsabschnitt des Grundbauteils fließen, dann übergehen in den Kühlfluidleitungsabschnitt des Kühlbauteils und danach in den weiteren Kühlfluidleitungsabschnitt des Grundbauteils.

Allgemein gesprochen kann gemäß einer weiteren Ausbildung der vorgenannten Ausführungsform entsprechend vorgesehen sein, dass der Kühlfluidleitungsabschnitt des bewegbar mit dem Grundbauteil verbundenen Kühlbauteils einen zweiten vorzugsweise endständigen, insbesondere hohlzylindrischen Hohlkörper(teil)abschnitt aufweist, dass ein weiterer bzw. zweiter Kühlfluidleitungsabschnitt des Grundbauteils einen vorzugsweise endständigen, insbesondere hohlzylindrischen Hohlkörper(teil)abschnitt aufweist, und dass für die bewegbare Verbindung von Grundbauteil und Kühlbauteil auch diese beiden Hohlkörper(teil)abschnitte, insbesondere gleitend, axial bewegbar und fluidleitend miteinander verbunden sind. Dies ebenfalls bevorzugt, indem der eine Hohlkörperabschnitt, insbesondere der zweite Hohlkörperabschnitt des Kühlbauteils, passgenau koaxial in den Innenraum des anderen Hohlkörperabschnitts, insbesondere des Hohlkörperabschnitts der weiteren Kühlfluidleitung des Grundbauteils, eingesetzt ist, vorzugsweise ebenfalls unter Verwendung mindestens eines die beiden Hohlkörperabschnitte gegeneinander fluiddicht abdichtenden Dichtrings.

Der Kühlkörper des Kühlbauteils kann sich entlang einer Ebene erstrecken, die winklig, insbesondere senkrecht zu den beiden entgegengesetzten Bewegungsrichtungen verläuft, in die das Kühlbauteil und das Grundbauteil relativ zueinander bedarfsweise aufeinander zu- bzw. voneinander wegbewegbar sind.

Eine Innenseite des sich insbesondere in einer queraxialen Ebene (queraxial mit Blick auf die axiale Relativbewegung zwischen den jeweiligen Hohlkörperabschnitten) erstreckenden Kühlkörpers kann im Übrigen eine der das Kühlmedium begrenzenden Wandinnenflächen des Kühlfluidleitungsabschnitts des Kühlbauteils bilden. Entsprechend würde/könnte das Kühlmedium im Betrieb der Kühleinrichtung innenseitig unmittelbar an dem Kühlkörper vorbeifließen und die Abwärme des zu kühlenden Gegenstands aufnehmen.

Vorzugsweise können der Innenseite des Kühlkörpers gegenüberliegende Wandinnenflächen des Kühlfluidleitungsabschnitts des Kühlbauteils Kraft-Kompensationsflächen bilden, sodass durch den Druck eines durch das Kühlbauteil strömenden Kühlfluids bewirkte, auf die Innenseite des Kühlkörpers wirkende, insbesondere axiale Fluiddruckkräfte (axial mit Bezug auf die axiale Relativbewegung zwischen den jeweiligen Hohlkörperabschnitten) durch entsprechende entgegengerichtete, auf diese Kraft-Kompensationsflächen wirkende, insbesondere axiale Fluiddruckkräfte in ihrer Wirkung aufgehoben werden. Hierdurch wird trotz der erfindungsgemäßen Bewegbarkeit des Kühlbauteils relativ zu dem Grundbauteil beispielsweise verhindert, dass der bewegbare Kühlkörper - ausgelöst durch den Fluiddruck - Kräfte auf die Anlagefläche des von ihm zu kühlenden Gegenstands ausübt, was insbesondere bei empfindlichen Gegenständen ansonsten problematisch sein könnte.

Eine der Kraft-Kompensationsflächen kann zweckmäßigerweise von einer sich insbesondere queraxial erstreckenden Wandinnenfläche des oder jedes Hohlkörperabschnitts des Kühlbauteils gebildet sein, die einen endständigen, sich insbesondere queraxial erstreckenden Anschlusskanal dieses Hohlkörperabschnitts begrenzt, über den Kühlfluid von dem Kühlfluidabschnitt des Grundkörpers zu dem Kühlfluidabschnitt des Kühlbauteils (oder umgekehrt) fließen kann.

Das bewegbar mit dem Grundbauteil verbundene Kühlbauteil kann des Weiteren mit dem Grundbauteil mittels eines vorzugsweise sich einerseits an dem Grundbauteil, andererseits an dem Kühlbauteil abstützenden, vorspannbaren Spannelements der Kühleinrichtung wirkverbunden sein, bevorzugt mittels einer Feder. Insbesondere mittels eines solchen Spannelements, dessen Vorspannung durch eine Relativbewegung zwischen dem Kühlbauteil und dem Grundbauteil bewirkt werden kann, die das Kühlbauteil und das Grundbauteil aufeinander zubewegt bzw. aufeinander zubewegen würde.

Das Spannelement kann in seinem vorgespanntem Zustand Kräfte auf das Kühlbauteil und das Grundbauteil ausüben, die das Kühlbauteil und das Grundbauteil voneinander wegbewegen oder wegbewegen würden, sodass ggf. - falls dies gewünscht ist - auf die Anlagefläche des zu kühlenden Gegenstands Anpress- bzw. Andrückkräfte ausgeübt werden können, sodass im Betrieb eine stabile Wärmeübertragung zwischen Kühlkörper und Anlagefläche garantiert ist.

Das Grundbauteil kann im Übrigen einen ersten Grundkörper aus insbesondere spritzgegossenem Kunststoff aufweisen, der insbesondere unter Bildung von einem oder mehreren Kühlfluidleitungsabschnitten fluiddicht verbunden ist mit einem insbesondere tiefgezogenen, vorzugsweise massiven, insbesondere aus Metall oder einer wärmeleitenden Metalllegierung bestehenden zweiten Grundkörper des Grundbauteils.

Ein oder jeder Hohlkörperabschnitt des Kühlfluidleitungsabschnitts des Grundbauteils kann dabei vorzugsweise durch den ersten Grundkörper aus Kunststoff gebildet sein.

Weiter kann ein oder jeder Hohlkörperabschnitt des Kühlfluidleitungsabschnitts des Grundbauteils ausgehend von einer ersten (insbesondere großflächigen) Seite des zweiten Grundkörpers des Grundbauteils ein (ggf. jeweiliges) Durchtrittsloch in diesem zweiten Grundkörper durchgreifen, auf bzw. jenseits einer bzw. der der ersten Seite gegenüberliegenden (insbesondere großflächigen) Seite des zweiten Grundkörpers enden und insbesondere dort mit einem oder jeweils einem Hohlkörperabschnitt des Kühlfluidleitungsabschnitts des bewegbar mit dem Grundbauteil verbundenen Kühlbauteils axial bewegbar verbunden sein.

Der zweite Grundkörper des Grundbauteils kann im Übrigen gemäß einer weiteren Ausführungsform der Erfindung zumindest bereichsweise einen weiteren Kühlkörper zur Aufnahme von Abwärme von zu kühlenden Gegenständen sowie zur Weiterleitung der Abwärme an im Betrieb der Kühleinrichtung durch die Kühlfluidleitung der Kühleinrichtung fließendem Kühlfluid bilden. Dies insbesondere, indem der zweite Grundkörper mindestens einen Kühlbereich aufweist, dessen Innenseite, die einer an einem kühlenden Gegenstand anordenbaren Außenseite (insbesondere unmittelbar ohne seitlichen Versatz) gegenüberliegt, eine Wandinnenfläche eines Kühlfluidleitungsabschnitts des Grundbauteils bildet.

Das bewegbar mit dem Grundbauteil verbundene Kühlbauteil kann des Weiteren über einen insbesondere spritzgegossenen Grundkörper aus Kunststoff verfügen, der zusammen mit dem Kühlkörper, mit dessen Innenseite dieser Grundkörper des Kühlbauteils fluiddicht verbunden ist, einen Teilabschnitt des Kühlfluidleitungsabschnitts des Kühlbauteils bildet. Der Grundkörper aus Kunststoff kann dabei des Weiteren zugleich den oder jeden Hohlkörperabschnitt des Kühlfluidleitungsabschnitts des Kühlbauteils bilden bzw. formen bzw. der oder die Hohlkörperabschnitte können entsprechend durch den Grundkörper aus Kunststoff geformt sein.

Der oben erwähnte, durch den Grundkörper aus Kunststoff des Kühlbauteils und den Kühlkörper des Kühlbauteils gebildete, insbesondere queraxial verlaufende Teilabschnitt des Kühlfluidleitungsabschnitts des Kühlbauteils kann dabei des Weiteren die beiden Hohlkörperabschnitte des Kühlfluidleitungsabschnitts des Kühlbauteils fluidleitend miteinander verbinden.

Was die fluiddichte Verbindung des ersten Grundkörpers aus Kunststoff des Grundbauteils der Kühleinrichtung mit dem zweiten Grundkörper des Grundbauteils betrifft und/oder die fluiddichte Verbindung des Kühlkörpers des Kühlbauteils mit dem Grundkörper aus Kunststoff des Kühlbauteils, so ist diese vorzugsweise eine stoff- und/oder formschlüssige Verbindung.

An dieser stoff- und/oder formschlüssigen Verbindung können dabei vorzugsweise durch physikalische und/oder chemische Verfahren erzeugte Nano- und/oder Mikrostrukturen beteiligt sein, die in die Oberfläche des Verbindungsbereichs des zweiten Grundkörpers des Grundbauteils bzw. in der Oberfläche des Verbindungsbereichs des Kühlkörpers des Kühlbauteils eingebracht sind. Insbesondere Nano- und/oder Mikrostrukturen, die eine Vergrößerung der Oberfläche in dem Verbindungsbereich bewirken und/oder Hinterschneidungen umfassende Vertiefungen aufweisen und/oder Widerhaken.

Weitere Merkmale der vorliegenden Erfindung ergeben sich aus den beigefügten Patentansprüchen, der nachfolgenden Beschreibung bevorzugter Ausführungsbeispiele sowie aus den beigefügten Zeichnungen.

Darin zeigt:
- Fig. 1: eine erste Ausführungsform einer erfindungsgemäßen Kühleinrichtung mit einem Grundbauteil und einem relativ zu diesem bewegbarem Kühlbauteil in Schrägansicht von oben; gemeinsam mit einem von diesem zu kühlenden Gegenstand, nämlich einem Computer-Chip,
- Fig. 2: eine isolierte Darstellung des Kühlbauteils der Kühleinrichtung aus Fig. 1 gemeinsam mit dem zu kühlenden Gegenstand in Schrägansicht von oben,
- Fig. 3: eine isolierte Darstellung des Grundbauteils aus Fig. 1 in Schrägansicht von unten,
- Fig. 4: die Kühleinrichtung aus Fig. 1 mit dem zu kühlenden Gegenstand in einem Längsschnitt,
- Fig. 5: die Kühleinrichtung aus Fig. 1 mit dem zu kühlenden Gegenstand in einem Querschnitt,
- Fig. 6: eine zweite Ausführungsform einer erfindungsgemäßen Kühleinrichtung mit einem Grundbauteil und einem relativ zu diesem bewegbaren Kühlbauteil in Schrägansicht von oben; gemeinsam mit einem von diesem zu kühlenden Gegenstand, nämlich einem Computer-Chip,
- Fig. 7: eine isolierte Darstellung des Kühlbauteils der Kühleinrichtung aus Fig. 6 gemeinsam mit dem zu kühlenden Gegenstand in Schrägansicht von oben,
- Fig. 8: eine isolierte Darstellung des Grundbauteils aus Fig. 6 in Schrägansicht von unten,
- Fig. 9: die Kühleinrichtung aus Fig. 6 mit dem zu kühlenden Gegenstand in einem Längsschnitt,
- Fig. 10: die Kühleinrichtung aus Fig. 6 mit dem zu kühlenden Gegenstand in einem Querschnitt.

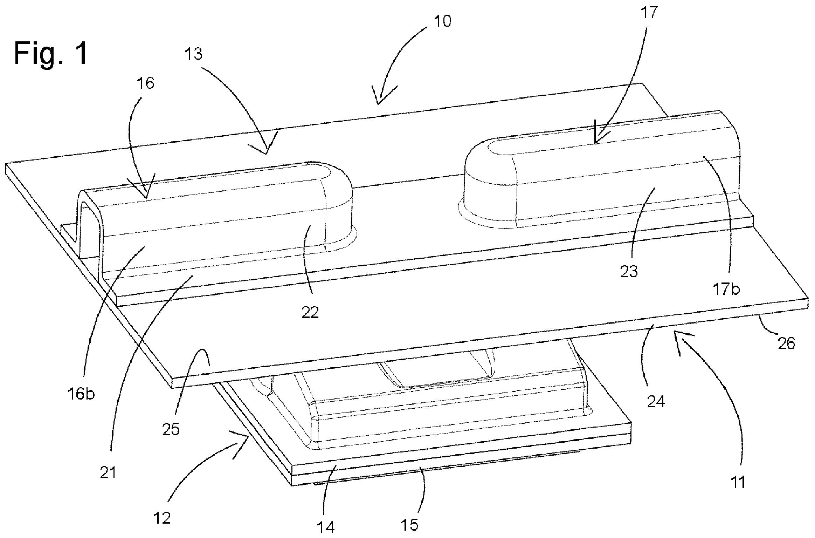

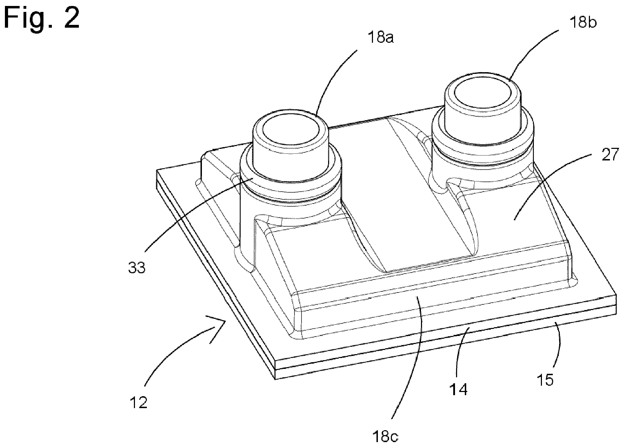

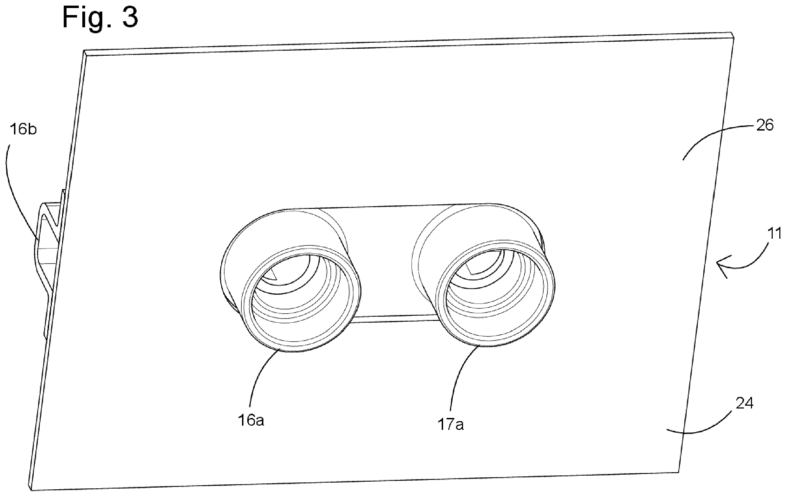

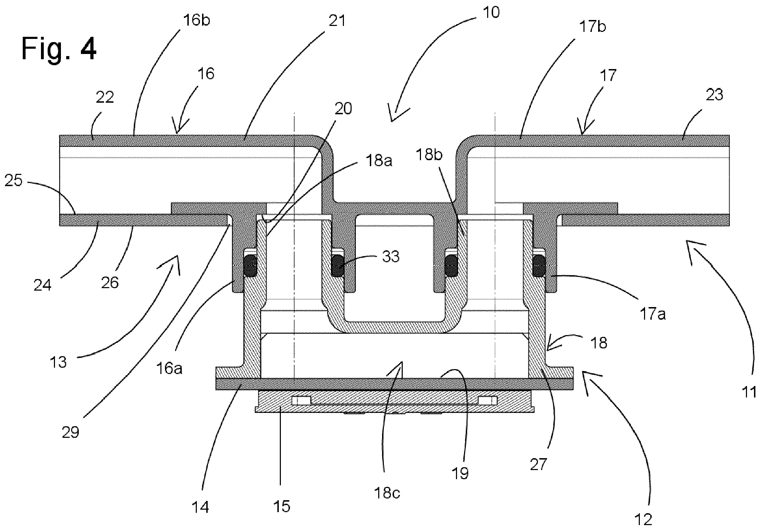

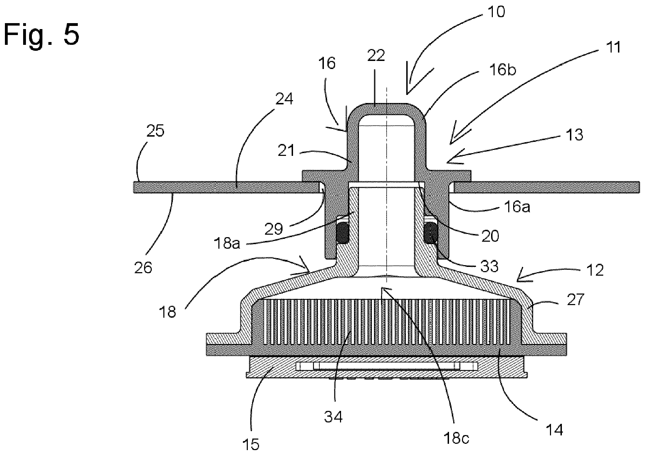

In den Figuren 1-5 ist eine Kühleinrichtung 10 gezeigt, die erfindungsgemäß ein Grundbauteil 11 sowie ein relativ zu diesem bewegbares Kühlbauteil 12 aufweist.

Die Kühleinrichtung 10 verfügt des Weiteren über eine Kühlfluidleitung 13, über die entlang eines Kühlkörpers 14 der Kühleinrichtung 10 Kühlfluid, wie etwa Wasser, geführt werden kann, um von dem Kühlkörper 14 aufgenommene Abwärme eines zu kühlenden Gegenstandes 15, im vorliegenden Fall exemplarisch ein Hochleistungscomputerchip, abzuleiten.

Die Kühleinrichtung 10 ist dabei Teil eines ansonsten bekannten Kühlsystems, das unter anderem eine Kühlfluidquelle aufweist sowie eine Pumpe, die das Kühlfluid durch die Kühlfluidleitung 13 der Kühleinrichtung 10 fördert (jeweils nicht gezeigt).

Wie nachfolgend noch näher beschrieben wird, setzt sich die Kühlfluidleitung 13 der Kühleinrichtung 10 aus mehreren Abschnitten zusammen.

Das Grundbauteil 11 weist dabei vorliegend einen Kühlfluidleitungsabschnitt 16 und einen Kühlfluidleitungsabschnitt 17 der Kühlfluidleitung 13 auf sowie das Kühlbauteil 12 einen Kühlfluidleitungsabschnitt 18.

Das Kühlfluid wird im Betrieb der Kühleinrichtung 10 bzw. des Kühlsystems ausgehend von der Kühlfluidquelle dem Kühlfluidleitungsabschnitt 16 des Grundbauteils 11 zugeführt, fließt dann durch den Kühlfluidleitungsabschnitt 18 des Kühlbauteils 12, nimmt dort die Abwärme des (vorliegend mit einer Vielzahl von Kühlrippen 34 versehenen) Kühlkörpers 14 auf, indem es entlang einer eine Wandinnenseite des Kühlfluidleitungsabschnitts 18 bildenden Innenseite 19 des Kühlkörpers 14 fließt, und fließt schließlich in den Kühlfluidleitungsabschnitt 17 des Grundbauteils 11, von dem aus es dann zur Kühlfluidquelle zurückgeführt wird.

Sowohl der Kühlfluidleitungsabschnitt 16 als auch der Kühlfluidleitungsabschnitt 17 des Grundbauteils 11 verfügen jeweils über einen endständigen Hohlkörperabschnitt 16a bzw. 17a, der jeweils einen ersten Teilabschnitt des jeweiligen Kühlfluidleitungsabschnitts 16 bzw. 17 bildet.

Die endständigen Hohlkörperabschnitte 16a und 17a des Kühlfluidleitungsabschnitts 16 bzw. 17 sind im vorliegenden Fall Bestandteile eines ersten Grundkörpers 21 aus Kunststoff, der zudem einstückig mit diesen Hohlkörperabschnitten 16a, 17a verbundene Leitungswandungen 22 bzw. 23 aufweist.

Diese Leitungswandungen 22 und 23 bilden zusammen mit einem plattenförmigen zweiten, massiven Grundkörper 24 des Grundbauteils 11 aus Metall, vorliegend aus Aluminium, mit dem sie fluiddicht verbunden sind, senkrecht zu den Hohlkörperabschnitten 16a, 17a bzw. bzw. queraxial zu diesen verlaufende weitere Kühlfluidleitungsteilabschnitte 16b bzw. 17b des jeweiligen Kühlfluidleitungsabschnitts 16 bzw. 17. An diese weiteren Kühlfluidleitungsteilabschnitte 16a und 17b schließen die Hohlkörperabschnitte 16a bzw. 17a dabei jeweils fluidleitend (einstückig) unmittelbar an.

Die Hohlkörperabschnitte 16a und 17a des jeweiligen Kühlfluidleitungsabschnitts 16 bzw. 17 des Grundbauteils 11 durchgreifen jeweils ausgehend von einer ersten großflächigen Seite 25 des zweiten Grundkörpers 24 des Grundbauteils 11 jeweils ein Durchtrittsloch 29 in diesem zweiten Grundkörper 24 und enden auf bzw. jenseits der der ersten Seite 25 gegenüberliegenden, großflächigen zweiten Seite 26 des zweiten Grundkörpers 24.

Auch der Kühlfluidleitungsabschnitt 18 des Kühlbauteils 12 verfügt jeweils über Hohlkörperabschnitte 18a bzw. 18b, die entsprechend Teilabschnitte des Kühlfluidleitungsabschnitts 18 des Kühlbauteils 12 bilden.

Auf der zweiten Seite 26 des zweiten Grundkörpers 24 sind jeweils paarweise einerseits die Hohlkörperabschnitte 16a und 18a miteinander verbunden sowie andererseits die Hohlkörperabschnitte 17a und 18b.

Diese Verbindungen sind derart ausgebildet, dass jeweils (gleitende) axiale Relativbewegungen zwischen den Hohlkörperabschnitten des jeweiligen Hohlkörperabschnittspaares 16a, 18a bzw. 17a, 18b möglich sind (die beispielsweise ein Werker bei Bedarf initiieren könnte), sodass im Ergebnis auch das Grundbauteil 11 und das Kühlbauteil 12 relativ zueinander bewegt werden können.

Jeder Hohlkörperabschnitt 18a und 18b weist in einem Verbindungsbereich, in dem die Hohlkörperabschnitte 16a, 18a bzw. 17a, 18b entsprechend gleitend miteinander verbunden sind, endständig einen Außendurchmesser auf, der geringfügig kleiner ist als der Innendurchmesser des jeweils zugeordneten Hohlkörperabschnitts 16a bzw. 17a der Kühlfluidleitung 16 bzw. 17 des Grundbauteils 11, sodass bei der Herstellung der Kühleinrichtung 10 jeder Hohlkörperabschnitt 18a, 18b passgenau koaxial in den Innenraum des jeweils zugeordneten Hohlkörperabschnitt 16a bzw. 16b eingesetzt werden konnte.

Hierdurch können die Hohlkörperabschnitte 16a und 18a bzw. die Hohlkörperabschnitte 17a und 18b und somit auch das Kühlbauteil 12 einerseits und das Grundbauteil 11 andererseits bei Bedarf von einem Werker jeweils (unter Überwindung von Reib- bzw. Haltekräften) relativ zueinander in Axialrichtung bewegt werden, nämlich entweder aufeinander zu oder voneinander weg.

Mittels jeweils eines Dichtrings 33, der unter Anlage außen an dem Hohlkörperabschnitt 18a bzw. 18b und innen an dem Hohlkörperabschnitt 16a bzw. 17a zwischen den jeweiligen Paaren der einander zugeordneten Hohlkörperabschnitte 16a, 18a bzw. 17a, 18b angeordnet ist, wird Fluiddichtigkeit erreicht bzw. erreicht, dass Fluid nicht im jeweiligen Verbindungsbereich zwischen den Hohlkörperabschnitten jedes Paares 16a, 18a bzw. 17a, 18b nach außen fließen kann.

Wie erkennbar ist sind den Möglichkeiten, das Kühlbauteil 12 und das Grundbauteil 11 bei Bedarf axial aufeinander zu-bewegen zu können, durch eine jeweilige Anschlagfläche 20 bzw. einen Endanschlag des Hohlkörperabschnitts 16a bzw. 17a des Grundbauteils 11 Grenzen gesetzt, gegen die das jeweilige freie Ende des Hohlkörperabschnitts 18a bzw. 18b ggf. des Kühlbauteils 12 schlägt.

Auch den Möglichkeiten, das Kühlbauteil 12 und das Grundbauteil 11 axial voneinander weg-bewegen zu können, sind Grenzen gesetzt, da ab einer gewissen Distanz zwischen diesen die Hohlkörperabschnitte 18a bzw. 18b so weit aus den Hohlkörperabschnitten 16a bzw. 17a herausgezogen werden würden, dass keine fluiddichte Verbindung mehr gegeben ist.

Das bewegbar mit dem Grundbauteil 11 verbundene Kühlbauteil 12 verfügt im Übrigen vorliegend über einen insbesondere spritzgegossenen Grundkörper 27 aus Kunststoff, der zum einen die die jeweiligen Teilabschnitte des Kühlfluidleitungsabschnitts 18 bildenden Hohlkörperabschnitte 18a, 18b des Kühlfluidleitungsabschnitts 18 des Kühlbauteils 12 bildet und der zum anderen zusammen mit dem Kühlkörper 14, mit dessen Innenseite 19 der Grundkörper 27 fluiddicht verbunden ist, einen die beiden Hohlkörperabschnitte 18a, 18b fluidleitend miteinander verbindenden, queraxial verlaufenden Teilabschnitt 18c des Kühlfluidleitungsabschnitts 18 bildet.

Dieser queraxial bzw. senkrecht zu den Hohlkörperabschnitten 18a, 18b verlaufende Teilabschnitt 18c wird durch den Grundkörper 27 und den Kühlkörper 14 des Kühlbauteils 12 gebildet bzw. durch dessen Innenseite 19.

Was die fluiddichte Verbindung der Grundkörper 21 und 24 des Grundbauteils 11 miteinander betrifft, also des ersten Grundkörpers 21 aus Kunststoff mit dem zweiten Grundkörper 24 aus Metall, so ist dies vorliegend eine stoff- und/oder formschlüssige Verbindung. An dieser sind durch physikalische und/oder chemische Verfahren erzeugte Nano- und/oder Mikrostrukturen in der Metalloberfläche des entsprechenden Verbindungsbereichs des zweiten Grundkörpers 24 aus Metall des Grundbauteils 11 beteiligt. Vorzugsweise sind dies Nano- und/oder Mikrostrukturen, die eine Vergrößerung der Metalloberfläche in dem Verbindungsbereich bewirken und/oder Hinterschneidungen umfassende Vertiefungen aufweisen und/oder Widerhaken.

In gleicher Weise kann auch die fluiddichte Verbindung des Metall-Kühlkörpers 14 des Kühlbauteils 12 mit dessen Kunststoff-Grundkörper 27 ausgebildet sein.

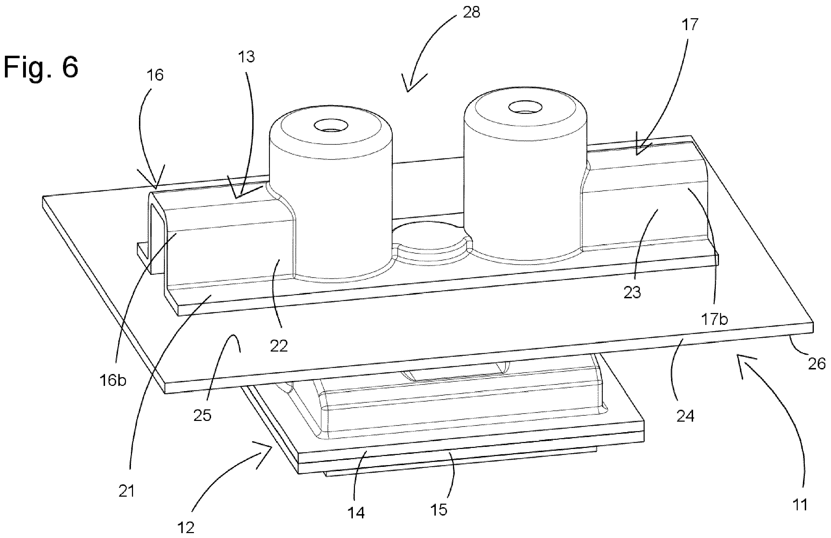

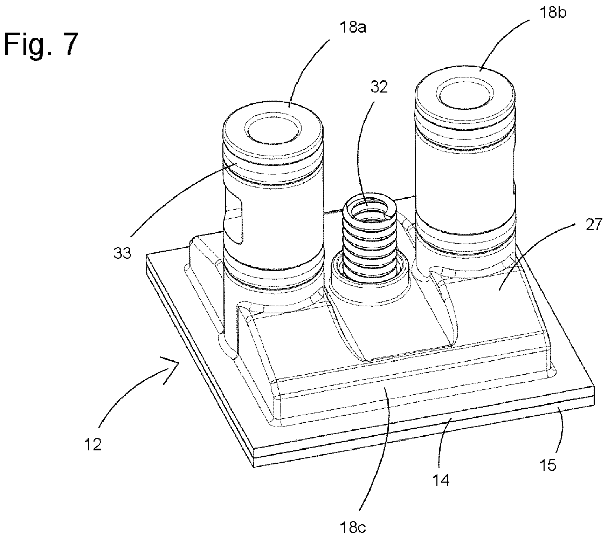

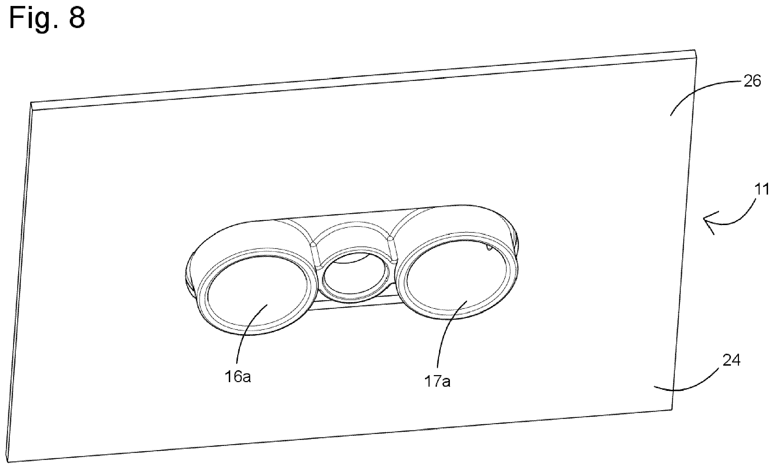

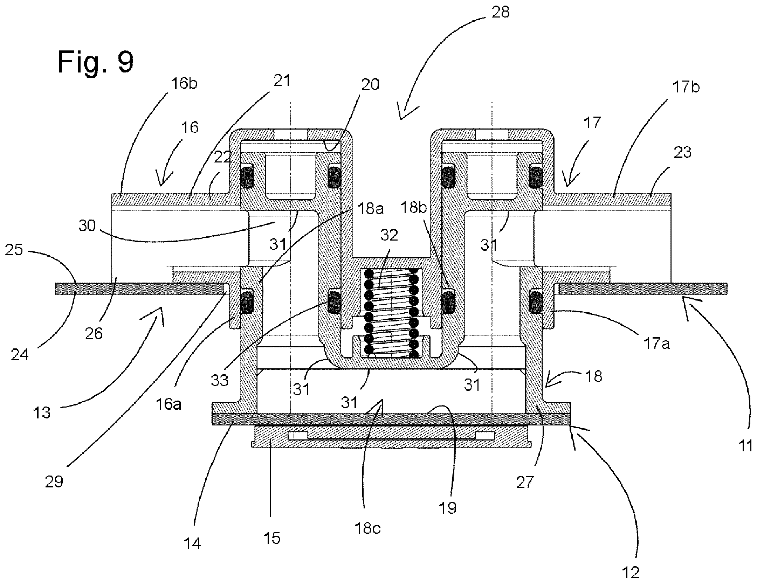

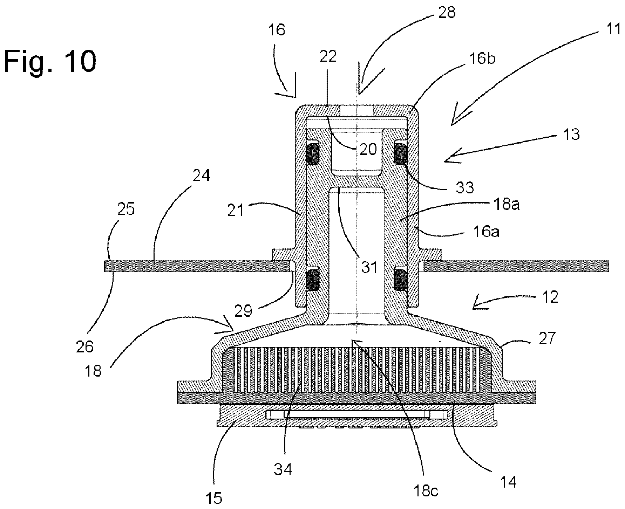

In den Figuren 6-10 ist eine weitere Ausführungsform 28 einer erfindungsgemäßen Kühleinrichtung gezeigt. Gleiche bzw. gleichartige Bauteile sind mit den gleichen Bezugsziffern wie bei der Kühleinrichtung 10 versehen, soweit dies nicht anders angegeben ist. Es wird nachfolgend - soweit nicht anders angegeben - vornehmlich auf die Unterschiede der Kühleinrichtung 28 zu der Kühleinrichtung 10 eingegangen.

Eine Besonderheit der Kühleinrichtung 28 besteht darin, dass das Kühlbauteil 12 desselben geeignet angeordnete und ausgebildete Kraft-Kompensationsflächen 31 aufweist, die dafür sorgen, dass im Ergebnis Fluiddruck des Kühlfluids, das im Betrieb der Kühleinrichtung 28 durch diese strömt, keine resultierenden axialen Kräfte auslöst (also Kräfte in Bewegungsrichtung des Kühlbauteils 12 bzw. in Richtung der Relativbewegung zwischen den Paaren von Hohlkörperabschnitten 16a, 18a bzw. 17a, 18b), die ggf. den zu kühlenden Gegenstand 15 schädigen könnten. Denn etwaige axiale, in Richtung des kühlenden Gegenstands 15 auf den Kühlkörper 14 wirkende Kräfte des Kühlfluids werden bei der Kühleinrichtung 28 durch entsprechende, in entgegengesetzte Richtung wirkende axiale Gegenkräfte kompensiert, die das Kühlfluid gleichzeitig auf die Kraft-Kompensationsflächen 31 ausübt.

Zu diesem Zweck erstreckt sich bei der Kühleinrichtung 28 (im Gegensatz zu der Kühleinrichtung 10) jeder Hohlkörperabschnitt 18a, 18b ausgehend von der zweiten Seite 26 des zweiten Grundkörpers 24 des Grundbauteils 11 (von unten) durch das jeweilige Durchtrittsloch 29 hindurch und endet jenseits bzw. auf der ersten Seite 25 des zweiten Grundkörpers 24, und zwar unter Bildung eines jeweiligen, sich queraxial erstreckenden Anschlusskanals 30, der an den sich (koaxial zu diesem) auf der ersten Seite 25 des zweiten Grundkörpers 24 erstreckenden Kühlfluidleitungsteilabschnitt 16b bzw. 17b anschließt und dessen sich queraxial erstreckende Wandinnenfläche (ein Bereich derselben) eine der Kraft-Kompensationsflächen 31 bildet.

Auch die Hohlkörperabschnitte 16a, 17a, in die die Hohlkörperabschnitte 18a bzw. 18b eingesteckt sind, erstrecken sich im Übrigen ebenfalls zum Großteil auf der ersten Seite 26 des zweiten Grundkörpers 24 des Grundbauteils 11.

Eine weitere Besonderheit der Kühleinrichtung 28 besteht darin, dass das Kühlbauteil 12 mit dem Grundbauteil 11 mittels eines sich vorliegend einerseits an dem Grundbauteil 11, andererseits an dem Kühlbauteil 12 abstützenden, vorspannbaren Spannelements 32 der Kühleinrichtung wirkverbunden ist, vorliegend mittels einer Feder.

Mithilfe des Spannelements 32 werden dann im Betrieb, in dem das Grundbauteil 11 in der Regel ortsfest positioniert wird, gezielt (in den Zeichnungen nach unten gerichtete) Kräfte auf das Kühlbauteil 12 ausgeübt, die dazu führen, dass der Kühlkörper 14 des Kühlbauteils 12 gezielt gegen den zu kühlenden Gegenstand 15 gedrückt bzw. gepresst wird, sodass eine dauerhafte Anlage des Kühlkörpers 14 an dem zu kühlenden Gegenstand 15 und somit eine optimale Wärmeübertragung zwischen dem zu kühlenden Gegenstand 15 und dem Kühlkörper 14 gewährleistet ist.

**Bezugszeichenliste:**

| | | | |
|---|---|---|---|
| 10 | Kühleinrichtung | 25 | erste Seite zweiter Grundkörper |
| 11 | Grundbauteil | | Grundbauteil |
| 12 | Kühlbauteil | 26 | zweite Seite Grundkörper |
| 13 | Kühlfluidleitung Kühleinrichtung | | Grundbauteil |
| 14 | Kühlkörper | 27 | Grundkörper Kühlbauteil |
| 15 | zu kühlender Gegenstand | 28 | Kühleinrichtung |
| 16 | Kühlfluidleitungsabschnitt | 29 | Durchtrittsloch |
| | Grundbauteil | 30 | Anschlusskanal |
| 16a | Hohlkörperabschnitt | 31 | Kraft-Kompensationsflächen |
| 16b | Kühlfluidleitungsteilabschnitt | 32 | Spannelement |
| 17 | Kühlfluidleitungsabschnitt | 33 | Dichtring |
| | Grundbauteil | 34 | Kühlrippen |
| 17a | Hohlkörperabschnitt | | |
| 17b | Kühlfluidleitungsteilabschnitt | | |
| 18 | Kühlfluidleitungsabschnitt | | |
| | Kühlbauteil | | |
| 18a | Hohlkörperabschnitt | | |
| 18b | Hohlkörperabschnitt | | |
| 18c | queraxialer | | |
| | Kühlfluidleitungsteilabschnitt | | |
| 19 | Innenseite Kühlkörper | | |
| 20 | Anschlagfläche Hohlkörperabschnitt | | |
| 21 | erster Grundkörper Grundbauteil | | |
| 22 | Leitungswand | | |
| 23 | Leitungswand | | |
| 24 | zweiter Grundkörper Grundbauteil | | |

## Patentansprüche

1. Kühleinrichtung zum Abführen von Wärme eines zu kühlenden Gegenstands, wie etwa einer insbesondere auf einer Leiterplatte angeordneten Elektronikkomponente, beispielsweise eines Chips, mit einer Kühlfluidleitung zum Durchfluss von Kühlfluid, mit einem Grundbauteil (11), das einen oder mehrere Kühlfluidleitungsabschnitte der Kühlfluidleitung aufweist, und mit einem an einem zu kühlenden Gegenstand anordenbaren, insbesondere aus massivem Material bestehenden, vorzugsweise plattenförmigen Kühlkörper (14) zur Aufnahme von Abwärme von dem zu kühlenden Gegenstand sowie zur Weiterleitung der Abwärme an im Betrieb der Kühleinrichtung durch die Kühlfluidleitung der Kühleinrichtung fließendes Kühlfluid, insbesondere einem solchen Kühlkörper (14) aus Metall oder einer wärmeleitenden Metalllegierung,
**dadurch gekennzeichnet, dass** der Kühlkörper (14) an einem mindestens einen Kühlfluidleitungsabschnitt der Kühlfluidleitung aufweisenden Kühlbauteil (12) der Kühleinrichtung angeordnet ist, das unter fluidleitendem Anschluss dieses Kühlfluidleitungsabschnitts an einen Kühlfluidleitungsabschnitt des Grundbauteils (11) bewegbar mit dem Grundbauteil (11) verbunden ist, sodass das Kühlbauteil (12) und das Grundbauteil (11) zur Anpassung der Position des Kühlkörpers (14) des Kühlbauteils (12) bedarfsweise relativ zueinander entweder aufeinander zu- oder voneinander wegbewegt werden können.

2. Kühleinrichtung gemäß Anspruch 1, **dadurch gekennzeichnet, dass** der Kühlkörper (14) des bewegbar mit dem Grundbauteil (11) verbundenen Kühlbauteils (12) plattenförmig ausgebildet ist und/oder Kühlrippen aufweist und sich entlang einer Ebene erstreckt, die winklig, insbesondere senkrecht zu den beiden entgegengesetzten Bewegungsrichtungen verläuft, in die das Kühlbauteil (12) und das Grundbauteil (11) relativ zueinander bedarfsweise aufeinander zu- bzw. voneinander weg-bewegbar sind.

3. Kühleinrichtung gemäß Anspruch 1 oder 2, **dadurch gekennzeichnet, dass** der Kühlfluidleitungsabschnitt des Grundbauteils (11) und der Kühlfluidleitungsabschnitt des bewegbar mit dem Grundbauteil (11) verbundenen Kühlbauteils (12) jeweils einen vorzugsweise endständigen, insbesondere hohlzylindrischen Hohlkörperabschnitt aufweisen, und dass für die bewegbare Verbindung von Grundbauteil (11) und Kühlbauteil (12) die beiden Hohlkörperabschnitte, insbesondere gleitend, axial bewegbar fluidleitend miteinander verbunden sind, bevorzugt, indem der eine Hohlkörperabschnitt, insbesondere der Hohlkörperabschnitt des Kühlbauteils (12), passgenau koaxial in den Innenraum des anderen Hohlkörperabschnitts, insbesondere des Hohlkörperabschnitts des Grundbauteils (11), eingesetzt ist, vorzugsweise unter Verwendung eines die beiden Hohlkörperabschnitte gegeneinander fluiddicht abdichtenden Dichtrings.

4. Kühleinrichtung gemäß Anspruch 3, **dadurch gekennzeichnet, dass** der Kühlfluidleitungsabschnitt des bewegbar mit dem Grundbauteil (11) verbundenen Kühlbauteils (12) einen zweiten endständigen, insbesondere hohlzylindrischen Hohlkörperabschnitt aufweist, dass ein zweiter Kühlfluidleitungsabschnitt des Grundbauteils (11) ebenfalls einen vorzugsweise endständigen, insbesondere hohlzylindrischen Hohlkörperabschnitt aufweist, und dass für die bewegbare Verbindung von Grundbauteil (11) und Kühlbauteil (12) auch diese beiden Hohlkörperabschnitte, insbesondere gleitend, axial bewegbar und fluidleitend miteinander verbunden sind, bevorzugt, indem der eine Hohlkörperabschnitt, insbesondere der zweite Hohlkörperabschnitt des Kühlbauteils (12), passgenau koaxial in den Innenraum des anderen Hohlkörperabschnitts, insbesondere des Hohlkörperabschnitts des zweiten Kühlfluidleitungsabschnitts des Grundbauteils (11), eingesetzt ist, vorzugsweise unter Verwendung eines die beiden Hohlkörperabschnitte gegeneinander fluiddicht abdichtenden Dichtrings.

5. Kühleinrichtung gemäß einem oder mehreren der vorhergehenden Ansprüche, **dadurch gekennzeichnet, dass** eine Innenseite des sich insbesondere in einer queraxialen Ebene erstreckenden Kühlkörpers (14) des bewegbar mit dem Grundbauteil (11) verbundenen Kühlbauteils (12) eine der das Kühlmedium begrenzenden Wandinnenflächen des Kühlfluidleitungsabschnitts des Kühlbauteils (12) bildet.

6. Kühleinrichtung gemäß einem oder mehreren der vorhergehenden Ansprüche, **dadurch gekennzeichnet, dass** der Innenseite des Kühlkörpers (14) gegenüberliegende Wandinnenflächen des Kühlfluidleitungsabschnitts des Kühlbauteils (12) Kraft-Kompensationsflächen bilden, sodass durch den Druck eines durch das Kühlbauteil (12) strömenden Fluids bewirkte, auf die Innenseite des Kühlkörpers (14) wirkende, insbesondere axiale Fluiddruckkräfte durch entsprechende entgegengerichtete, auf diese Kompensationsflächen wirkende, insbesondere axiale Fluiddruckkräfte in ihrer Wirkung aufgehoben werden.

7. Kühleinrichtung gemäß einem oder mehreren der vorhergehenden Ansprüche, mindestens gemäß Anspruch 3 und Anspruch 6, **dadurch gekennzeichnet, dass** eine Kraft-Kompensationsfläche von einer sich insbesondere queraxial erstreckenden Wandinnenfläche des oder jedes Hohlkörperabschnitts des Kühlbauteils (12) gebildet ist, die einen endständigen, sich insbesondere queraxial erstreckenden Anschlusskanal dieses Hohlkörperabschnitts begrenzt, über den Kühlfluid von dem (jeweiligen) Kühlfluidabschnitt des Grundkörpers zu dem Kühlfluidabschnitt des Kühlbauteils (12) (oder umgekehrt) fließen kann.

8. Kühleinrichtung gemäß einem oder mehreren der vorhergehenden Ansprüche, **dadurch gekennzeichnet, dass** das bewegbar mit dem Grundbauteil (11) verbundene Kühlbauteil (12) mit dem Grundbauteil (11) mittels eines vorzugsweise sich einerseits an dem Grundbauteil (11), andererseits an dem Kühlbauteil (12) abstützenden, vorspannbaren Spannelements der Kühleinrichtung wirkverbunden ist, bevorzugt mittels einer Feder, insbesondere mittels eines solchen Spannelements, dessen Vorspannung durch eine Relativbewegung zwischen dem Kühlbauteil (12) und dem Grundbauteil (11) bewirkt werden kann, die das Kühlbauteil (12) und das Grundbauteil (11) aufeinander zubewegt bzw. aufeinander zubewegen könnte.

9. Kühleinrichtung gemäß Anspruch 8, **dadurch gekennzeichnet, dass** das Spannelement in seinem vorgespanntem Zustand Kräfte auf das Kühlbauteil (12) und das Grundbauteil (11) ausübt, die das Kühlbauteil (12) und das Grundbauteil (11) voneinander wegbewegen oder wegbewegen würden.

10. Kühleinrichtung gemäß einem oder mehreren der vorhergehenden Ansprüche, **dadurch gekennzeichnet, dass** das Grundbauteil (11) einen ersten Grundkörper aus insbesondere spritzgegossenem Kunststoff aufweist, der insbesondere unter Bildung von einem oder mehreren Kühlfluidleitungsabschnitten fluiddicht verbunden ist mit einem insbesondere tiefgezogenen zweiten, vorzugsweise massiven, insbesondere aus Metall oder einer wärmeleitenden Metalllegierung bestehenden Grundkörper.

11. Kühleinrichtung gemäß Anspruch 10, **dadurch gekennzeichnet, dass** ein oder jeder Hohlkörperabschnitt des Kühlfluidleitungsabschnitts des Grundbauteils (11) durch den ersten Grundkörper gebildet ist.

12. Kühleinrichtung gemäß Anspruch 10 oder 11, **dadurch gekennzeichnet, dass** ein oder jeder Hohlkörperabschnitt des Kühlfluidleitungsabschnitts des Grundbauteils (11) ausgehend von einer ersten (insbesondere großflächigen) Seite des zweiten Grundkörpers des Grundbauteils (11) ein (ggf. jeweiliges) Durchtrittsloch in diesem zweiten Grundkörper durchgreift, auf bzw. jenseits der der ersten Seite gegenüberliegenden (insbesondere großflächigen) Seite des zweiten Grundkörpers endet und insbesondere dort mit einem oder jeweils einem Hohlkörperabschnitt des Kühlfluidleitungsabschnitts des bewegbar mit dem Grundbauteil (11) verbundenen Kühlbauteils (12) axial bewegbar verbunden ist.

13. Kühleinrichtung gemäß einem oder mehreren der vorhergehenden Ansprüche 10 - 12, **dadurch gekennzeichnet, dass** der zweite Grundkörper zumindest bereichsweise einen weiteren Kühlkörper (24) bildet zur Aufnahme von Abwärme von zu kühlenden Gegenständen sowie zur Weiterleitung der Abwärme an im Betrieb der Kühleinrichtung durch die Kühlfluidleitung der Kühleinrichtung fließendes Kühlfluid, insbesondere, indem der zweite Grundkörper mindestens einen Kühlbereich aufweist, dessen Innenseite, die einer an einem kühlenden Gegenstand anordenbaren Außenseite gegenüberliegt, eine Wandinnenfläche eines Kühlfluidleitungsabschnitts des Grundbauteils (11) bildet.

14. Kühleinrichtung gemäß einem oder mehreren der vorhergehenden Ansprüche, **dadurch gekennzeichnet, dass** das bewegbar mit dem Grundbauteil (11) verbundene Kühlbauteil (12) über einen insbesondere spritzgegossenen Grundkörper aus Kunststoff verfügt, der zusammen mit dem Kühlkörper (14), mit dessen Innenseite der Grundkörper des Kühlbauteils (12) fluiddicht verbunden ist, einen Teilabschnitt des Kühlfluidleitungsabschnitts des Kühlbauteils (12) bildet, und der den oder jeden Hohlkörperabschnitt des Kühlfluidleitungsabschnitts des Kühlbauteils (12) bildet.

15. Kühleinrichtung gemäß Anspruch 14, **dadurch gekennzeichnet, dass** der durch den Grundkörper des Kühlbauteils (12) und den Kühlkörper (14) des Kühlbauteils (12) gebildete, insbesondere queraxial verlaufende Teilabschnitt des Kühlfluidleitungsabschnitts des Kühlbauteils (12) die beiden Hohlkörperabschnitte des Kühlfluidleitungsabschnitts des Kühlbauteils (12) fluidleitend miteinander verbindet.

16. Kühleinrichtung gemäß einem oder mehreren der vorhergehenden Ansprüche, **dadurch gekennzeichnet, dass** die fluiddichte Verbindung des ersten und des zweiten Grundkörpers des Grundbauteils (11) und/oder die fluiddichte Verbindung des Kühlkörpers des Kühlbauteils (12) mit dem Grundkörper des Kühlbauteils (12) eine stoff- und/oder formschlüssige Verbindung ist, und dass an dieser stoff- und/oder formschlüssigen Verbindung durch physikalische und/oder chemische Verfahren erzeugte Nano- und/oder Mikrostrukturen in der Oberfläche des Verbindungsbereichs des zweiten Grundkörpers des Grundbauteils (11) bzw. in der Oberfläche des Verbindungsbereichs des Kühlkörpers des Kühlbauteils (12) beteiligt sind, insbesondere Nano- und/oder Mikrostrukturen, die eine Vergrößerung der Oberfläche in dem Verbindungsbereich bewirken und/oder Hinterschneidungen umfassende Vertiefungen aufweisen und/oder Widerhaken.
